# EUROPÄISCHE PATENTSCHRIFT

(11) **EP 1 560 242 B1**
(45) Veröffentlichungstag und Bekanntmachung des Hinweises auf die Patenterteilung: **16.07.2008**
(21) Anmeldenummer: 04001824.4
(22) Anmeldetag: 28.01.2004
(51) Int. Cl.: H01H 37/76

(54) **Steuereinheit mit thermischem Schutz und eine die Steuereinheit umfassende elektrische Heizvorrichtung**
Controller with a thermal protector and a heating device incorporating the controller
Unité de contrôle avec un dispositif pour la protection thermique et un dispositif de chauffage comprenant une telle unité

(43) Veröffentlichungstag der Anmeldung: 03.08.2005
(73) Patentinhaber: Catem GmbH & Co.KG, 76863 Herxheim bei Landau/Pfalz (DE)
(72) Erfinder: Bohlender, Franz, 76870 Kandel (DE); Zeyen, Michael, 76819 Landau/Queichheim (DE); Niederer, Michael, 76889 Kapellen-Drusweiler (DE); Uhl, Günther, Dr., 74921 Helmstadt-Bargen (DE)
(74) Vertreter: Grünecker, Kinkeldey, Stockmair & Schwanhäusser Anwaltssozietät

(56) Entgegenhaltungen:
- EP-A- 0 706 194
- EP-A- 1 157 867
- FR-A- 2 521 770
- US-A- 4 758 876
- US-A- 5 280 262

## Beschreibung

Die vorliegende Erfindung betrifft eine Steuereinheit mit einer wenigstens eine Leiterbahn umfassenden Leiterplatte und einem auf der Leiterplatte befestigten und elektrisch mit der wenigstens einen Leiterbahn verbundenen Transistor.

Derartige Steuereinheiten, die einen Transistor als Halbleitersteuerelement umfassen, kommen in einer Vielzahl von Anwendungen zum Einsatz, so beispielsweise auch zur Steuerung von Antriebs-, Heizungs-, und Beleuchtungseinrichtungen in Kraftfahrzeugen und insbesondere überall dort, wo es auf Grund der Vielzahl von zu steuernden Einrichtungen einer Gesamtapparatur darauf ankommt, die einzelnen Steuereinheiten möglichst kostengünstig herzustellen.

Es sind verschiedene Anwendungen denkbar, bei denen es beispielsweise aufgrund des durch die Leiterbahn hindurchgeleiteten zu steuernden Stromes zu einer Überhitzung der Steuereinheit kommen kann. Solche Fehlfunktionen werden insbesondere durch Vorschädigungen des Transistors begründet. Diese Vorschädigungen treten zwar bei der Massenfertigung von Transistoren lediglich im ppm-Bereich auf. Da jedoch die Transistoren insbesondere bei der kostengünstigen Massenherstellung auf Spritzgießteilen angeordnet, bzw. von diesen umgeben werden, führt eine Überhitzung der Transistoren auch zu einer Überhitzung der umgebenden Kunststoffteile. Der Kunststoff beginnt bei den Temperaturen einer Überhitzung, beispielsweise im Bereich von 300°C, zu schmoren und im ungünstigsten Fall zu brennen. Dadurch kann die Vorrichtung, in welche die Steuereinheit eingebaut ist, zum Teil oder auch vollständig zerstört werden.

Solche Steuereinheiten kommen beispielsweise auch in elektrischen Heizvorrichtungen für Kraftfahrzeuge zum Einsatz, wie sie beispielsweise aus der EP-A-0 350 528 oder der EP-A-1 157 867 bekannt ist. Für den Einsatz in Kraftfahrzeugen, insbesondere Kraftfahrzeugen mit verbrauchsoptimierten Diesel- und zukünftig auch Benzinmotoren, in denen eine geringere Menge an Wärmeenergie anfällt, werden elektrische Zusatzheizungen zur Beheizung von Innenraum und Motor verwendet. Elektrischen Heizvorrichtungen sind auch für andere Einsatzzwecke geeignet, beispielsweise im Bereich von Hausinstallationen, insbesondere Raumklimatisierung, Industrieanlagen und dergleichen.

Durch die Verwendung von elektrischen Zusatzheizungen in der Heiz-/Klimaanlage eines Kraftfahrzeugs kann die Zeitdauer, in der die Abwärme des Motors noch nicht für Heizzwecke zur Verfügung steht, überbrückt werden. Elektrische Zusatzheizungen erreichen schon nach wenigen Sekunden ihre Betriebstemperatur und können somit die durchströmende Luft entsprechend aufheizen.

Für solche elektrischen Zusatzheizungen, die in Heiz-/Klimaanlagen von Kraftfahrzeugen eingesetzt werden, werden vorzugsweise PTC-Heizelemente verwendet, die elektrischen Strom in Wärme umsetzen. Die PTC-Heizelemente stehen mit Radiatorelementen der Zusatzheizung in wärmeleitender Verbindung. Die von den PTC-Heizelementen erzeugte Wärme wird über die Radiatorelemente an die durchströmende Luft abgegeben.

Die Gesamtanordnung aus einem geschichteten Aufbau von PTC-Heizelementen, Radiatorelementen und Kontaktblechen, die der Stromzufuhr dienen, ist zur Erhöhung des Wirkungsgrads einem Klemmdruck ausgesetzt. Durch die Klemmung wird eine Verbesserung der elektrischen und thermischen Kontaktierung der PTC-Heizelemente erreicht.

Die Steuerung der Heizleistung wird in zunehmendem Maße von Halbleiterbauelementen übemommen, die Relaissteuerungen ersetzen. Die Steuereinheiten regeln in Abhängigkeit von der angeforderten Heizleistung den den einzelnen PTC-Heizelementen zugeführten Strom. Vorzugsweise dienen die Halbleiterbauelemente als Schalter, die den einzelnen PTC-Heizelementen zugeführten Strom zu- oder abschalten. Zur exakteren Dosierung der Heizleistung kann mit Hilfe der Halbleiterbauelemente der den Heizelementen zugeführte Strom auch kontinuierlich eingestellt werden. Nachteilig an einer solchen kontinuierlichen Regelung ist die dabei anfallende hohe Verlustleistung, die in Wärme umgesetzt wird und damit ebenfalls zu einer Überhitzung beitragen kann.

Die zur Stromregelung eingesetzten Halbleiterbauelemente sind in einer Vielzahl von Varianten mit unterschiedlichen Zusatzfunktionen erhältlich. Aufwändige und teure Transistoren besitzen eine Mehrzahl sogenannter "smart power control" Funktionen. Mit deren Hilfe ist beispielsweise eine automatische Temperaturüberwachung des Transistors realisierbar. Nachteilig an solchen Transistoren ist jedoch ihr hoher Preis, so dass sie nur in hochpreisigen Fahrzeugen zum Einsatz kommen.

Bei einer Überhitzung einer derartigen Steuereinrichtung einer Zuheizung in einem Kraftfahrzeug breiten sich die beim Schmoren der Kunststoffe entstehenden Gase unmittelbar durch das Belüftungssystem des Kraftfahrzeuges aus und treten in den Fahrgastraum ein. Dabei werden in dem Fahrgastraum befindliche Personen durch die austretenden Gase unmittelbar gesundheitlich beeinträchtigt. Auch nebeln die austretenden Gase den Fahrgastraum ein und verschlechtern die Sicht des Fahrers nach draußen, versperren diese gar vollkommen.

Selbst bei einer Temperaturüberwachung des Transistors oder aber einer anderen elektronischen Überwachung der tatsächlichen Temperatur zur rechtzeitigen Abschaltung der Ströme vor Überhitzung besteht ebenfalls das Problem mangelnder Zuverlässigkeit des hierdurch verwirklichten Überhitzungsschutzes. Auch ein elektrischer Überhitzungsschutz der Steuereinheit stellt eine unbefriedigende Lösung dar, da auch hier die geforderte Zuverlässigkeit nicht immer erreicht wird. Im Übrigen führt die Verwirklichung eines elektrischen Überhitzungsschutzes bei zu überwachenden hohen Strömen zu einer Steuereinheit mit erheblicher Einbaugröße.

FR-A- 2 521 770 beschreibt einen elektro-mechanischen Überhitzungsschutz für eine Heiz- bzw. Kochplatte. Bei diesem Überhitzungsschutz ist auf einer Leiterplatte ein Unterbrecherelement in Form einer Feder mit einer von zwei gegenüberliegenden Leiterbahnen fest verbunden. Wird diese Feder entgegen ihrer Vorspannung in Kontakt mit der entsprechenden Leiterbahn gebracht, so wird ein elektrischer Stromkreis, der die Heizplatte versorgt, geschlossen. Um die Feder in der vorgespannten Position zu halten, ist ein Stift vorgesehen. Der Stift ist innerhalb einer Vertiefung der Heizplatte auf einem eingesetzten zylindrischen Körper aus schmelzbarem Material platziert. Im Falle einer Überhitzung schmilzt der Zylinder, so dass der Zylinder sowie der Stift der Federkraft des Unterbrecherelements nachgeben und so die elektrische Verbindung gelöst wird.

Aufgabe der Erfindung ist es, eine Steuereinheit mit einem zuverlässigen Überhitzungsschutz anzugeben.

Gemäß eines weiteren Aspekts der vorliegenden Erfindung soll eine elektrische Heizvorrichtung insbesondere für ein Kraftfahrzeug mit einer gegen Überhitzung geschützten Steuereinrichtung angeben werden.

Zur Lösung des ersten Aspekts der der Erfindung zugrunde liegenden Aufgabe wird mit dieser eine Steuereinheit mit den Merkmalen von Anspruch 1 angegeben, die erfindungsgemäß durch ein Unterbrecherelement mit einem diesem zugeordnetem Betätigungselement weitergebildet wird. Erfindungsgemäß verbindet das Unterbrecherelement in seiner gegenüber der Leiterplatte festgelegten Ausgangsstellung gegenüberliegende Enden wenigstens einer Leiterbahn elektrisch miteinander. Das vorerwähnte Betätigungselement ist ein bei Überhitzung des Transistors aktiviertes Betätigungselement. Dies bedeutet, dass das Betätigungselement erst bei Überschreiten einer unzulässig hohen Temperatur an dem Transistor betätigt wird. Bei einer derartigen thermisch induzierten Aktivierung des Betätigungselementes wirkt das Betätigungselement gegen das Unterbrecherelement, bis dieses so weit von der Leiterplatte gelöst ist, dass die elektrische Verbindung der beiden Enden der Leiterbahnen unterbrochen ist.

Mit der vorliegenden Erfindung wird gemäß dem ersten Aspekt dementsprechend eine elektro-mechanische Lösung angeboten, bei welcher ein im Falle der Überhitzung mechanisch bewegtes Unterbrecherelement von der Ausgangsstellung in eine Sicherungsstellung verlagert wird, um die elektrische Verbindung der zu dem Transistor führenden Leiterbahn zu unterbrechen. Das mit der Erfindung vorgeschlagene elektromechanische Lösungsprinzip gewährleistet einen zuverlässigen Überhitzungsschutz für die Steuereinheit, die in allen denkbaren Fällen zur Anwendung kommen kann, in denen eine Überhitzung der Steuereinheit zu befürchten ist. Diese Überhitzung kann beispielsweise durch den über die Leiterbahn geführten und von der Steuereinheit gesteuerten Strom, insbesondere in dem Transistor verursacht werden. Möglich ist aber auch ein Überhitzungsschutz für die Steuereinheit gegenüber Wärme, mit welcher die Steuereinheit aus ihrer unmittelbaren Umgebung beaufschlagt wird.

Gemäß der vorliegenden Erfindung ist das Betätigungselement in seiner Ausgangslage vorgespannt und durch ein thermisch mit dem Transistor gekoppeltes Schmelzelement gesichert. Hierbei hält das Schmelzelement das Betätigungselement in der Ausgangslage, in welcher das Betätigungselement in Wirkrichtung vorgespannt ist. Schmilzt das Schmelzelement, so gibt das Schmelzelement das Betätigungselement frei, welches sich von seiner Ausgangslage entfernt und hierbei unmittelbar oder mittelbar auf das Unterbrecherelement einwirkt. Die thermische Kopplung zwischen dem Schmelzelement und dem Transistor ist derart, dass jedenfalls bei unzulässig hohen Temperaturen im Transistor oder in unmittelbarer Nähe des Transistors das Schmelzelement abschmilzt. Als Schmelzelement kann beispielsweise ein Schmelzstift aus Acrylnitritbutadienstyrol (ABS) oder Polyvinylchlorid (PVC) zum Einsatz kommen. Mit dieser bevorzugten Ausgestaltung der vorliegenden Erfindung wird die thermische Aktivierung des Betätigungselementes auf einfache Weise verwirklicht.

Vorzugsweise ist das Schmelzelement auf der dem Transistor abgewandten Seite der Leiterplatte angeordnet und weist eine sich zwischen dem Schmelzelement und dem Transistor in der Leiterbahn erstreckende Wärmeleitbahn auf. Bei dieser Ausgestaltung befindet ist der Transistor vorzugsweise als SMD-Bauteil (Surface Mounted Device) auf der Oberseite der Leiterplatte befestigt, um in direktem thermischem Kontakt mit der Wärmeleitbahn zu stehen. Die im Bereich des Transistors einwirkende Temperatur wird über die Wärmeleitbahn auf die Unterseite der Leiterplatte geleitet, an welcher das Schmelzelement gegen die Leiterplatte gesichert ist, vorzugsweise unmittelbar gegen diese anliegt. Da das vorgespannte Betätigungselement über das Schmelzelement gesichert ist, liegt auch das Betätigungselement jedenfalls mittelbar unter Zwischenlage des Schmelzelementes gegen die Leiterplatte an, so dass der erfindungsgemäße elektro-mechanische Überhitzschutz mit wenigen zusätzlichen Teilen auf einfache Weise verwirklicht werden kann.

Die Wärmeleitbahn wird vorzugsweise aus einer Vielzahl von mit Lötzinn gefüllten Bohrungen in der Leiterplatte gebildet. Auf diese Weise kann die thermische Kontaktierung zwischen dem Transistor und dem thermischem Schutzelement von der mechanischen Kontaktierung entkoppelt werden. Dadurch wird ein guter thermischer Übergang bei mechanischer Entlastung der Lötstelle Transistor-Leiterplatte erreicht und deren Zuverlässigkeit erhöht.

Gemäß einer weiteren bevorzugten Ausgestaltung, die einen Kurzschluss durch das Unterbrecherelement im Falle einer Überhitzung verhindert und bei der die Sicherungsstellung desselben gesichert wird, ist dieses durch ein auf die Leiterplatte aufgelötetes Kontaktblech gebildet, wobei die transistorseitige Lötverbindung zwischen der Leiterplatte und dem Kontaktblech thermisch mit dem Transistor gekoppelt ist. Diese thermische Kopplung der Lötverbindung mit dem Transistor bewirkt bei Überhitzung ein Aufschmelzen des in der Lötverbindung befindlichen Lotes. Gleichzeitig wirkt thermisch induziert das Betätigungselement und bewegt das Kontaktblech. Eine weitere zwischen dem Kontaktblech und der Leiterplatte ausgebildete Lötverbindung ist thermisch so weit von dem Transistor entkoppelt, dass das Kontaktblech über diese Lötverbindung an der Leiterplatte gehalten bleibt. Dies erfolgt vorzugsweise dadurch, dass die Leiterplatte eine unter dem Kontaktblech ausgesparte Betätigungsöffnung aufweist, in der das betätigungsseitige Ende des Betätigungselementes in seiner Ausgangslage aufgenommen ist. Auf der einen Seite dieser Betätigungsöffnung befindet die thermisch mit dem Transistor gekoppelte Lötverbindung. Auf der anderen Seite die thermisch entkoppelte Lötverbindung, um welche das Kontaktblech im Falle einer Überhitzung vorzugsweise verschwenkt. Es steht dementsprechend nicht zu befürchten, dass das Kontaktblech sich im Falle einer Überhitzung des Transistors frei in der Steuereinheit bewegt und gegebenenfalls die unterbrochene elektrische Verbindung zwischen den beiden Enden der Leiterbahn unkontrolliert wieder herstellt.

Gemäß einer weiteren bevorzugten Ausgestaltung der vorliegenden Erfindung ist das Betätigungselement durch ein Stanzbiegeteil gebildet, welches gegenüber der Leiterplatte festgelegt ist. Dieses Stanzbiegeteil weist ein elastisch umbogenes Bogensegment sowie ein mit einer Aufnahme zur Halterung des Schmelzelementes versehenes Aufnahmesegment auf und hat ferner ein sich zwischen dem Bogensegment und dem Aufnahmesegment erstreckendes Verbindungssegment, von dem ein durch Einschneiden des Verbindungssegmentes gebildeter Betätigungssteg abgeht, der sich in etwa rechtwinklig zu der Leiterplatte erstreckt. Das vorerwähnte integral eine Feder ausbildende Stanzbiegeteil stellt eine besonders kostengünstig und leicht herzustellende Ausgestaltung des Betätigungselementes dar und wird im Hinblick auf eine möglichst kostengünstige Massenherstellung der erfindungsgemäßen Steuereinheit verwirklicht.

Zur Lösung des zweiten Aspektes der der Erfindung zugrunde liegenden Aufgabe wird erfindungsgemäß eine elektrische Heizvorrichtung umfassend ein Vorrichtungsgehäuse, das einen Schichtaufbau bestehend aus wenigstens einem Radiatorelement und wenigstens einem parallelen Kontaktblech, die zwischen sich wenigstens ein PTC-Heizelement aufnehmen, umfassenden wärmeabgebenden Element hält, angegeben. Diese beispielsweise aus der EP-A-0 350 528 bekannte elektrische Heizvorrichtung wird mit der vorliegenden Erfindung zur Schaffung einer zuverlässigen und kostengünstigen Sicherung gegen Überhitzung mit einer Steuereinheit gemäß einem der Ansprüche 1 bis 12 weitergebildet wird.

Vorzugsweise weist die elektrische Heizvorrichtung ein Aufnahmegehäuse auf, welches in an sich bekannter Weise eine sich quer zu den wärmeabgebenden Elementen erstreckende und diese elektrisch isoliert voneinander abstützende Querstrebe umfasst, an der die Leiterplatte sowie das Betätigungselement der erfindungsgemäßen Steuereinheit gehalten sind.

Im Folgenden wird die vorliegende Erfindung anhand bevorzugter Ausführungsbeispiele in Zusammenhang mit den beiliegenden Zeichnungen erläutert. Dabei zeigen die Zeichnungen im Einzelnen:
- Figur 1: ein Ausführungsbeispiel einer erfindungsgemäßen Steuereinheit in Explosionsdarstellung;
- Figur 2: das in Figur 1 gezeigte Ausführungsbeispiel in einer Längsschnittansicht;
- Figur 3: ein Ausführungsbeispiel einer elektrischen Heizvorrichtung als Zusatzheizer für ein Kraftfahrzeug mit einem Ausführungsbeispiel einer erfindungsgemäßen Steuereinheit; und
- Figur 4: den Ausschnitt A gemäß der Darstellung in Figur 3 in vergrößerter Darstellung.

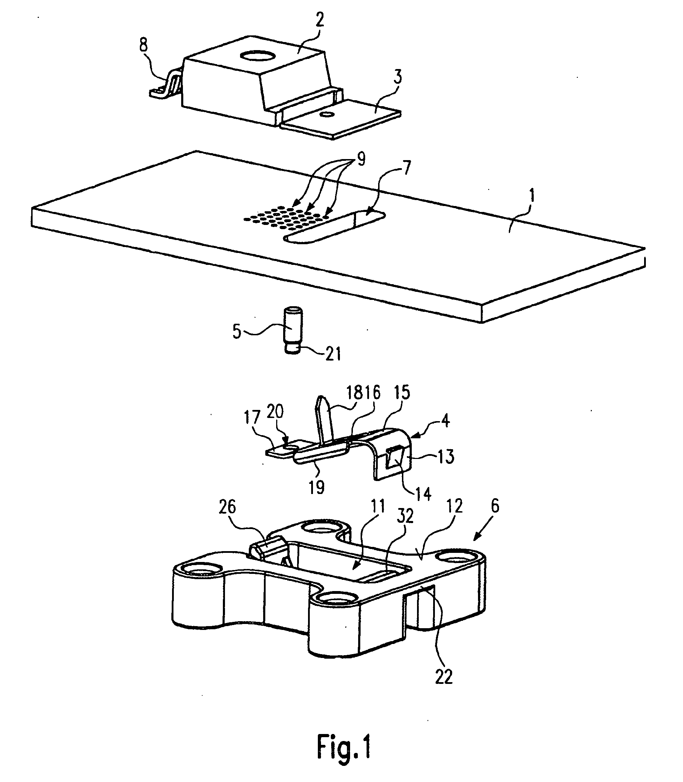

Die Figur 1 zeigt ein Ausführungsbeispiel einer erfindungsgemäßen Steuereinheit in Explosionsdarstellung. Die Steuereinheit umfasst eine Leiterplatte 1, eine Halbleitersteuerelement in Form eines Transistors 2 sowie ein als Kontaktblech 3 ausgebildetes Unterbrecherelement und ein durch ein Stanzbiegeteil 4 ausgebildetes Betätigungselement. Ferner ist zur Ausbildung eines Schmelzelementes ein Schmelzstift 5 sowie ein das Stanzbiegeteil 4 aufnehmendes spritzgegossenes Aufnahmegehäuse 6 verwirklicht.

Die Leiterplatte 1 weist auf ihrer dem Transistor 2 und dem Kontaktblech 3 zugeordneten Oberseite in der Zeichnung nicht dargestellte Leiterbahnen auf, die zu dem Transistor 2 führen. Dieser hat an seiner der Leiterplatte 1 zugewandten Befestigungsseite einen sogenannten Lead Frame, durch welchen der Transistor 2 elektrisch mit der wenigstens einen auf der Oberseite der Leiterplatte 1 ausgebildeten Leiterbahn verbunden ist. Diese Leiterbahn wird durch eine in der Leiterplatte 1 ausgesparte Betätigungsöffnung 7 durchbrochen, so dass zwei Enden der Leiterbahn an den gegenüberliegenden Seiten der Betätigungsöffnung zu der Oberfläche der Leiterplatte 1 freiliegen. Selbstverständlich können auch mehrere einander zugeordnete Enden weiterer Leiterbahnen an den gegenüberliegenden Seiten der Betätigungsöffnung 7 vorgesehen sein, die zu dem Transistor 2 führen.

Der Transistor 2 hat an seiner dem Kontaktblech 3 abgewandten Rückseite mehrere Anschlüsse 8, die elektrisch mit auf der Leiterplatte 1 ausgebildeten weiteren Leiterbahnen verbunden sind. Je mehr "smart power control"-Funktionen der Transistor aufweist, beispielsweise zur Temperatur und/oder Strommessung, umso mehr Anschlüsse sind erforderlich. Die in Figur 1 gezeigte Anzahl von Anschlüssen ist nur beispielhaft.

In der Leiterplatte 1 ist unterhalb des Transistors eine Vielzahl von Bohrungen 9 vorgesehen. Die Bohrungen sind verkupfert und können sich beim Lötvorgang mit Lot füllen. Die auf diese Weise gebildete Wärmeleitbahn 10 bewirkt eine gute Wärmeleitung vom Transistor zum Schmelzstift 5, ohne dass die Lötverbindung zwischen dem Transistor und der Leiterplatte mechanisch belastet und damit das Risiko einer schlechten elektrischen Verbindung in Kauf genommen wird.

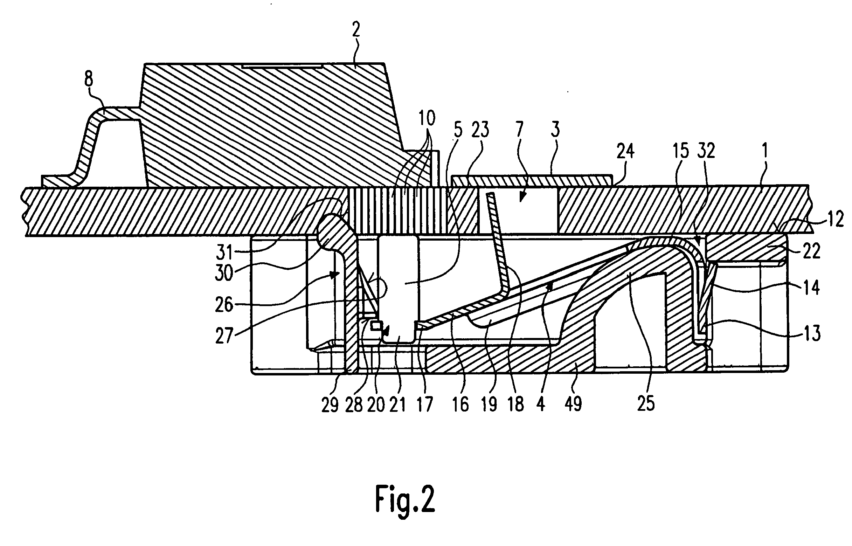

Das Aufnahmegehäuse 6 hat eine im Wesentlichen H-förmige Grundfläche, deren zentraler Steg eine mit einem Boden 49 (vgl. Fig. 2) versehene Aussparung 11 aufweist. Das Aufnahmegehäuse 6 bildet eine an die Unterseite der Leiterplatte 1 anlegbare ebene Montagefläche 12 aus. An den sich im Wesentlichen rechtwinklig zu dem zentralen Steg erstreckenden Querstegen des H-förmigen Aufnahmegehäuses 6 sind hier nicht dargestellte Rastelemente vorgesehen, die in ebenfalls nicht dargestellte und an der Leiterplatte 1 ausgesparte Rastbohrungen eingreifen, wenn das Aufnahmegehäuse 6 an der Leiterplatte 1 montiert ist und mit seiner Montagefläche 12 an der die Gegenfläche hierzu bildenden Unterseite der Leiterplatte 1 anliegt.

Das Stanzbiegeteil 4 ist durch einen mittels Stanzbearbeitung gebildeten Blechstreifen gebildet und umfasst ein Befestigungssegment 13 mit einer darin angeordneten ausgestanzten Rastlasche 14, ein sich an das Befestigungssegment 13 anschließendes Bogensegment 15, in dem im montierten Zustand elastische Anteile gespeichert sind, durch welche ein sich an das Bogensegment 15 anschließendes Verbindungssegment 16 sowie ein an dem freien Ende des Stanzbiegeteiles 4 vorgesehenes Aufnahmesegment 17 in Richtung auf die Leiterplatte 1 vorgespannt sind. Durch Einschneiden ist der mittlere Abschnitt des ebenen Verbindungssegmentes 16 freigeschnitten und in Richtung auf die Leiterplatte 1 zur Ausbildung eines Betätigungssteges 18 umbogen.

Das Verbindungssegment 16 weist ferner in einer der Biegerichtung des Betätigungssteges 18 gegenüberliegenden Richtung umbogene Versteifungswangen 19 auf, welche die Biegesteifigkeit des Verbindungssegmentes 16 erhöhen und die Durchbiegung des Verbindungssegmentes 16 aufgrund einer in Längsrichtung des Betätigungssteges 18 wirkenden Kraft vermindern.

Das Aufnahmesegment 17 weist eine durch Stanzbearbeitung ausgeformte Bohrung 20 auf, deren Durchmesser ein wenig größer als ein im Durchmesser gegenüber dem Schmelzstift 5 verminderter Verbindungszapfen 21 ist, der einteilig an dem befestigungsseitigen Ende des Schmelzstiftes 5 angeformt ist.

Der Schmelzstift 5 sollte aus einem Kunststoff gebildet sein, der bei einer vorbestimmten Schmelztemperatur beispielsweise von zwischen 100°C und 180°C abschmilzt, wenn die in dem Ausführungsbeispiel dargestellte Steuereinheit vor Überhitzung, beispielsweise vor Temperaturen von über 300°C abschalten soll. Der Schmelzvorgang beginnt ab erreichen einer vorgegebenen Temperatur. Die untere Grenze für die vorgegebene Temperatur entspricht in etwa der Temperatur, bei der das Lot weich wird bzw. schmilzt. Eine bevorzugte Temperatur für den Beginn des Schmelzvorgangs liegt bei ca. 100°C. Vorzugsweise ist der Schmelzstift aus ABS oder PVC in Form eines Zylinders mit einem Durchmesser von beispielsweise 1,5 bis 2 mm bei einer Länge von etwa 8 mm hergestellt.

Figur 2 zeigt eine Längsschnittansicht der in Figur 1 in Explosionsdarstellung gezeigten Teile. Gleiche Bauteile sind mit gleichen Bezugszeichen versehen. Es ist erkennbar, dass der Schmelzstift 5 im zusammengebauten Zustand zwischen dem Aufnahmesegment 17 und der Leiterplatte 1 aufgenommen ist. Der Schmelzstift 5 wird aufgrund der Vorspannung des Stanzbiegeteiles 4 gegen die Unterseite der Leiterplatte 1 gedrückt. Das leiterplattenseitige Ende des Schmelzstiftes 5 liegt damit an dem unterhalb des Transistors durchkontaktierten Bereich 10 an, wodurch der Schmelzstift 5 über die Wärmeleitbahn thermisch mit dem Transistor 2 gekoppelt ist.

Die Lage des Aufnahmegehäuse 6 relativ zu der Leiterplatte 1 ist ferner derart gewählt, dass in der in Figur 2 gezeigten Ausgangslage des Stanzbiegeteiles 4, in dem dieses gegenüber der Leiterplatte 1 vorgespannt ist, der Betätigungssteg 18 in der Betätigungsöffnung 7 mit geringem Abstand zu dem Kontaktblech 3 aufgenommen ist.

Die Rastlasche 14 des Stanzbiegeteiles 4 hintergreift einen einteilig an dem Aufnahmegehäuse 6 ausgebildeten Steg 22 und ist hierdurch unverlierbar in dem Aufnahmegehäuse 6 aufgenommen.

Das Kontaktblech 3 liegt auf der Oberseite der Leiterplatte 1 an und ist über eine transistorseitige Lötverbindung 23 und eine auf der anderen Seite der Betätigungsöffnung 7 vorgesehene Lötverbindung 24 mit der Leiterplatte 1 verbunden. Die Lötverbindung 24 ist lediglich im Bereich derjenigen stirnseitigen Kante des Kontaktbleches 3 vorgesehen, die sich rechtwinklig zu der Zeichnungsebene der Figur 2 erstreckt.

In der in Figur 2 gezeigten Ausgangslage drückt der die Bohrung 20 umgebende Rand des Stanzbiegeteiles 4 gegen einen zwischen dem Verbindungszapfen 21 und dem Schmelzstift 5 ausgebildeten Kragen. Der Schmelzstift 5 hält das Stanzbiegeteil 4 in seiner in Figur 2 dargestellten federvorgespannten Ausgangslage, in der das Stanzbiegeteil mit seinem Bogensegment 13 an einem gewölbten Widerlager 25, welches an dem Boden 49 des Aufnahmegehäuses 6 ausgebildet ist, anliegt.

Kommt es nun zu einer Überhitzung im Bereich des Transistors 2, beispielsweise aufgrund einer mechanischen Vorschädigung (z.B. durch "chip cracks") oder einer elektrischen Überlastung ("electrical overstress") unmittelbar in dem Transistor 2, so wird die in dem Transistor 2 erzeugte Wärme durch Wärmeleitung an die transistorseitige Lötverbindung 23 und den Schmelzstift 5 übertragen. Die Wärmeleitung zu dem Schmelzstift erfolgt über die Wärmeleitbahn 10, wohingegen der Abstand zwischen dem Transistor 2 und der transistorseitigen Lötverbindung 23, also der Abstand zwischen dem Transistor 2 und dem Kontaktblech 3 so gewählt ist, dass die von dem Transistor abgegebene Wärme bei einer unzulässigen Erwärmung des Transistors auf beispielsweise 300°C zu einer Erwärmung der Lötverbindung 24 oberhalb der Schmelztemperatur des Lotes führt. Hierzu kann die transistorseitige Lotverbindung 23 in unmittelbarer Nähe zu den Kupferstiften 10 ausgebildet sein, welche aufgrund ihrer dichten Packung in der Leiterplatte 1 Wärme bevorzugt auch in Plattenrichtung der Leiterplatte 1 leiten.

Durch die übertragene Wärme schmilzt der Schmelzstift 5 langsam ab. Aufgrund der Federvorspannung des Stanzbiegeteiles 4 führt dieses die abgeschmolzene Länge des Schmelzstiftes 5 nach, so dass der Schmelzstift 5 weiterhin an der Unterseite des durchkontaktierten Bereichs 10 der Leiterplatte anliegt.

Das zunächst in der Ausgangslage mit geringem Abstand zu dem Kontaktblech 3 in der Betätigungsöffnung 7 aufgenommene betätigungsseitige Ende des Betätigungssteges 18 drückt nun gegen das Kontaktblech 3. Die von dem Transistor erzeugte und in Plattenrichtung zu der transistorseitigen Lötverbindung 23 geleitete Wärme führt zu einem Aufschmelzen der transistorseitigen Lötverbindung 23. Da der Betätigungssteg 18 benachbart zu dem transistorseitigen Rand der Betätigungsöffnung 7 gegen das Kontaktblech 3 drückt, wird dieses nunmehr von der Leiterplatte 1 abgehoben und um die andere Lötverbindung 24 verschwenkt, die durch die Betätigungsöffnung 7 thermisch von dem Transistor 2 entkoppelt ist, so dass das Lot der anderen Lotverbindung 24 fest bleibt. Die im Bereich der Kante des Kontaktbleches 3 verwirklichte Lotverbindung 24 wirkt hierbei wie ein Scharnier. Beim Abheben des Kontaktbleches 3 von der Leiterplatte wird der Kontakt der beiden Enden der auf der Oberfläche der Leiterplatte 1 ausgebildeten Leiterbahn unterbrochen. Eine weitere Erwärmung des Transistors 2 aufgrund des durch diese Leiterbahn fließenden Stromes ist danach ausgeschlossen und der Transistor 2 wird gegen Überhitzung geschützt.

Das in den Figuren 1 und 2 gezeigte Ausführungsbeispiel weist ein Riegelelement 26 auf, welches die Vormontage des Stanzbiegeteiles 4 in einem vorgespannten Zustand erlaubt. Dieses Riegelelement 26 ist in Fig. 2 in einer Stellung gezeigt, in der das Riegelelement 26 das in dem aus dem Stanzbiegeteil 4 und dem Aufnahmegehäuse 6 bestehenden vormontierten Betätigungselement gehaltene Stanzbiegeteil 4 unter Vorspannung fixiert. Tatsächlich befindet sich jedoch das Riegelelement 26 nach Befestigen der vormontierten Betätigungseinheit an der Leiterplatte 1 in einer gegenüber der in Fig. 2 gezeigten Stellung in einer nach links verschwenkten Stellung, die nachfolgend näher beschrieben wird.

Wie insbesondere der Darstellung in Fig. 2 zu entnehmen ist, ist das Riegelelement 26 als im Wesentlichen plattenförmiges Bauteil ausgebildet, welches sich über die gesamte Breite der Aussparung 11 erstreckt. Das Riegelelement 26 weist an seiner der Aussparung 11 zugewandten Innenfläche eine Ablauframpe 27 auf, die sich ausgehend von der Innenfläche des Riegelelementes 26 nach unter hin verbreitet. Dieser Ablauframpe 27 ist eine sich im Wesentlichen rechtwinklig zu der Längserstreckung des Riegelelements 26 erstreckende Anlagefläche 28 nachgeordnet. In der in Fig. 2 gezeigten vormontierten Stellung des Riegelelementes 26 hintergreift das Stanzbiegeteil 4 mit seinem Aufnahmesegment 17 die Ablauframpe 27 und liegt an der Anlagefläche 28 an. Die Ablauframpe 27 befindet sich an einem Rand des plattenförmigen Riegelelementes 26 und - bezogen auf die Zeichenebene nach Fig. 2 - hinter dem Schmelzstift 5.

Das Riegelelement 26 ist als einteiliges Spritzgießteil über ein Filmscharnier als Teil des Aufnahmegehäuses 6 ausgebildet. Das Filmscharnier befindet sich jeweils an dem stirnseitigen Ende des Riegelelementes 26 und verbindet dieses mit den Seitenwänden der Aussparung 11, und zwar am unteren Ende 29 des Riegelelementes 26. In der in den Fig. 1 und 2 gezeigten vormontierten Stellung des Riegelelementes 26 überragt das andere Ende des Riegelelementes 26 die Montagefläche 12 und weist einen sich zu der der Ablauframpe 27 abgewandten Seite neigenden abgekröpften Kopf 30 auf, der eine in Neigungsrichtung der Ablauframpe 27 geneigte Gleitfläche 31 ausbildet.

Nachfolgend wird die Vormontage der Betätigungseinheit zunächst unter Bezugnahme auf Fig. 1 beschrieben. Das Aufnahmegehäuse 6 wird fixiert und das Stanzbiegeteil 4 wird mit seinem Befestigungssegment 13 in einen an dem Aufnahmegehäuse 6 zwischen dem Steg 22 und dem gewölbten Widedager 25 ausgeformten Aufnahmeschlitz 32 so weit eingeschoben, bis die Rastlasche 14 den Steg 22 hintergreift. Danach wird das Stanzbiegeteil 4 in die Aussparung 11 im Wesentlichen unter elastischer Biegung des Bogensegmentes 15 durch Anlage an dem Widerlager 25 eingebracht. Das hierbei in die Aussparung 11 eintretende Aufnahmesegment 17 wirkt am Ende dieser Einbringbewegung mit der Ablauframpe 27 zusammen und verdrängt das Riegelelement 26 aus der Aussparung 11. Das Riegelelement 26 wird hierbei um seine Filmscharniere verschwenkt. Im Bereich des Filmscharniers werden elastische Teile in dieses eingeprägt. Sobald das Aufnahmesegment 17 den Übergang zwischen der Ablauframpe 27 und der Anlagefläche 28 passiert hat, wird das Riegelelement 26 aufgrund der elastischen Anteile in Richtung auf die Aussparung 11 zurückverschwenkt. Die Anlagefläche 28 wird hierbei über das Aufnahmesegment 17 gebracht. Das Stanzbiegeteil 4 ist nunmehr in der aus dem Stanzbiegeteil 4 und dem Aufnahmegehäuse 6 mit Riegelelement 26 gebildeten vormontierten Betätigungseinheit unter Vorspannung fixiert.

Diese Sicherung des Stanzbiegeteils 4 kann jedoch durch Verschenken des Riegelelementes 26 aus der Aussparung 11 gelöst werden. Diese Schwenkbewegung wird bei der Befestigung der vormontierten Betätigungseinheit zwangsläufig in der nachstehend beschriebenen Weise aufgeprägt. Die vormontierte Betätigungseinheit wird unter die Leiteplatte 1 gebracht, und zwar derart, dass die an der Leiterplatte 1 vorgesehenen Rastbohrungen mit den an dem Aufnahmegehäuse 6 ausgebildeten Rastelemente fluchten. Der Schmelzstift 5 wurde vorzugsweise in einem vorgelagerten Montageschritt mit seinem Verbindungszapfen 21 in die Bohrung 20 des Stanzbiegeteils 4 eingebracht.

Nun werden die vormontierte Betätigungseinheit und die Leiterplatte 1 aufeinander zu bewegt. Dabei tritt zunächst das betätigungsseitige Ende des Betätigungssteges 18 in die Betätigungsöffnung 7 ein. Bei fortschreitender Bewegung legt sich der Kopf 30 mit seiner Gleitfläche 31 an die Unterseite der Leiterplatte 1 und gleitet mit seiner Gleitfläche 31 an der Unterseite der Leiterplatte 1 ab. Daraus resultiert die Verschwenkbewegung des Riegelelementes 26 um sein unteres Ende 29 aus der Aussparung 11, durch die die Rastverbindung zwischen dem Stanzbiegeteil 4 und der Anlagefläche 28 des Riegelelements 26 aufgehoben wird. Schließlich wird die vormontierte Betätigungseinheit durch Verrasten der Rastelemente an der Leiterplatte 1 mit dieser verklipst. Das Riegelelement 26 befindet sich nunmehr in einer gegenüber der Darstellung in Fig. 2 nach links verschwenkten Lage, in der die Ablauframpe 27 mit der ihr zugeordneten Anlagefläche 28 so weit aus der Aussparung 11 herausgedrängt ist, dass diese einer Nachführbewegung des Stanzbiegeteils 4 bei abschmelzendem Schmelzstift 5 keinen Widerstand entgegensetzt.

Die vorstehend beschriebene vormontierte Betätigungseinheit bietet den Vorteil, dass das unter Vorspannung im vormontierten Zustand gehaltene Stanzbiegeteil 4 zwangsläufig beim Anbringen der vormontierten Betätigungseinheit an die Leiterplatte 1 freigegeben wird. Dementsprechend erlaubt die Ausgestaltung nicht nur eine vereinfachte Montage des Temperaturschutzes an der Leiterplatte 1, sondern verhindert auch Montagefehler und verbessert dementsprechend die Zuverlässigkeit des Überhitzungsschutzes.

Die erfindungsgemäße Steuereinheit mit dem thermischen Schutzelement ist überall da einsetzbar, wo eine von der Steuereinheit ausgehende Wärmeentwicklung eine Gefährdung der Gesamtvorrichtung darstellt. Erfindungsgemäß kann eine Überhitzung und ein dadurch bewirkter Folgeschaden zuverlässig verhindert werden. Vorzugweise wird die vorliegende Erfindung in elektrischen Zusatzheizungen für Kraftfahrzeuge eingesetzt, und zwar sowohl in Zusatzheizung mit integrierter Steuereinheit als auch bei Zusatzheizungen mit separater Steuereinheit.

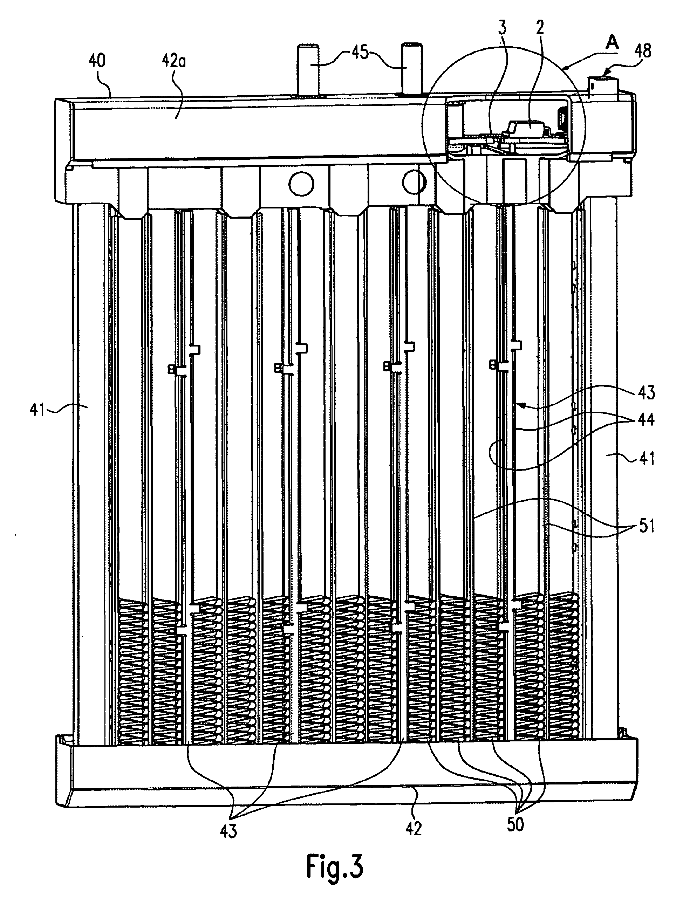

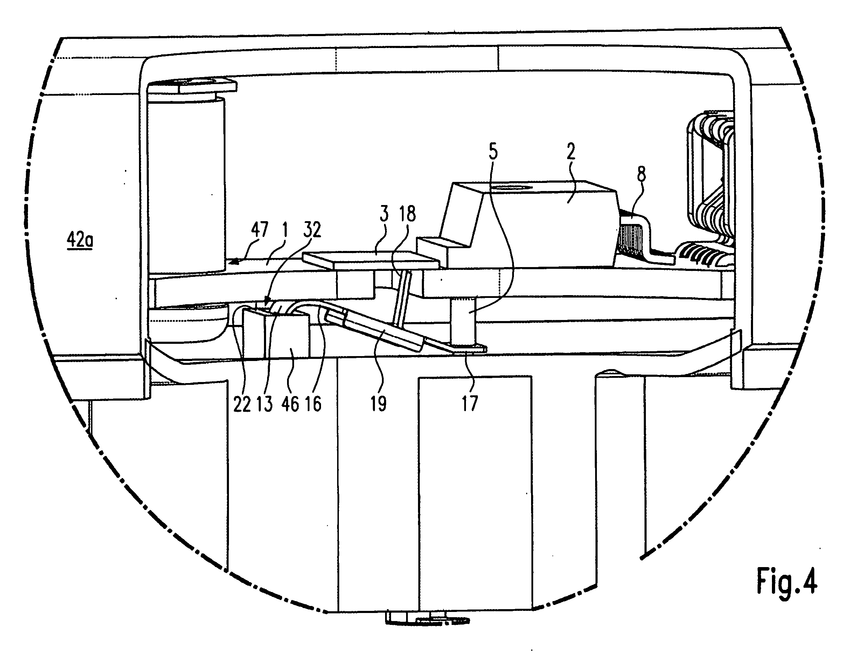

Die Figuren 3 und 4 zeigen ein Ausführungsbeispiel einer elektrischen Heizvorrichtung für ein Kraftfahrzeug mit einem weiteren Ausführungsbeispiel einer erfindungsgemäßen Steuereinheit, die in einem gemeinsamen Gehäuse mit den Heizelementen eine baulich Einheit bildet. Das in Figur 3 gezeigte Gehäuse ist nur beispielhaft. Die vorliegende Erfindung lässt sich auch in beliebig gestaltete andere Gehäuseformen integrieren.

Die in Figur 3 gezeigte elektrische Heizvorrichtung besitzt ein rahmenförmiges Gehäuse 40, welches durch zwei sich in Längsrichtung erstreckende vertiefte metallische Stege oder Längsholme 41 und zwei sich hierzu rechtwinklig erstreckende aus Kunststoff spritzgegossene Stege bzw. Querholme 42 gebildet ist. Die elektrische Heizvorrichtung weist sich parallel zu den Längsholmen 41 erstreckende Schichten aus Radiatorelementen 50 und wärmeabgebenden Schichten 43 auf. Jeder der wärmeabgebenden Schichten umfasst jeweils ein oder mehrere PTC-Heizelemente, die zwischen zwei parallelen elektrisch und Wärme leitenden Kontaktblechen 44 gehalten, insbesondere geklemmt sind. Diese Kontaktbleche 44 können als separate Bauteile in Form von Flachprofilbändern oder durch die ebene Außenfläche von Radiatorelementen, die beispielsweise durch Aluminium-Strangpressen hergestellt sind, ausgebildet sein. Wesentlich für die Funktion der Kontaktbleche ist lediglich eine gute wärme- und elektrischleitende Anlage der PTC-Heizelemente an den sich gegenüber liegenden Kontaktblechen 44. Vorliegend sind die Radiatorelementen 50 jeweils durch einen Strang eines mäanderförmig gebogenen Radiatorbleches gebildet.

Bei dem in Fig. 3 gezeigten Ausführungsbeispiel sind vier wärmeabgebende Schichten 43 vorgesehen, deren Kontaktbleche 44 elektrisch voneinander isoliert in den Stegen 42 gehalten sind. Der in Fig. 3 obere Haltesteg 42a ist kastenförmig ausgebildet und enthält eine Steuereinheit zur Einstellung des den PTC-Heizelementen zuzuführenden Stroms. Der obere Haltesteg 42a wird von zwei elektrischen Anschlusszapfen 45 überragt, durch die der elektrische Anschluss der gezeigten Heizvorrichtung an das Bordnetz eines Kraftfahrzeuges erfolgt. Der in einen der Anschlusszapfen 45 eingebrachte Heizstrom wird von den den wärmeabgebenden Schichten zugeordneten Transistoren 2 zu- oder abgeschaltet, so dass die Heizleistung der elektrischen Heizvorrichtung stufenweise regulierbar ist.

Eine der Heizstufen kann so ausgestaltet sein, dass die Heizleistung dieser Stufe kontinuierlich einstellbar ist, so dass die Gesamtheizleistung genauer dosierbar ist und Temperatursprünge in der dem Innenraum zugeführten Luft vermieden werden.

Der Überhitzschutz für den diese Steuerung übernehmenden Transistor 2 ist in Fig. 4 dargestellt. Gleiche Bauteile sind gegenüber den Fig. 1 und 2 auch hier mit gleichen Bezugszeichen gekennzeichnet. Im Gegensatz zu dem zuvor beschriebenen Ausführungsbeispiel befindet sich das Stanzbiegeteil mit seinem Befestigungssegment 13 in einem zylindrischen Befestigungsvorsprung 46, welcher den Aufnahmeschlitz 32 sowie den zum Verrasten des Stanzbiegeteils 4 vorgesehenen Steg 22 ausbildet. Der Befestigungsvorsprung 46 ist als einteiliges Bauteil an dem Haltesteg 42a mittels Spritzgießen ausgeformt.

Über die in Fig. 4 dargestellte Bolzen 47 wird der Heizstrom von den Anschlussbolzen 45 auf die einzelnen Heizstufen verteilt.

Das in den Fig. 3 und 4 gezeigte Ausführungsbeispiel kann ebenso gut eine vormontierte Betätigungseinheit aufweisen, welche durch Einschieben in den oberen Haltesteg 42a in eine vorgegebene Position gebracht wird, in welcher die auf der Leiteplatte 1 aufgebrachten Leiterbahnen elektrisch mit den wärmeabgebenden Elementen 43 und hierüber mit einem der Anschlusszapfen 45 verbunden sind. Der elektrische Anschluss des Transistors 2 an den anderen Anschlusszapfen 45 kann beispielsweise durch Einschieben und/oder Verlöten von elektrischen Kontaktelementen erfolgen, die auch die übrigen Anschlüsse 8 mit einem angedeuteten Steckerelement 48 für Steuerleitungen zu dem Transistor 2 verbinden.

Zusammenfassend wird erfindungsgemäß eine Steuereinheit mit einem thermischen Schutzelement angegeben, dass eine Abschaltung der Stromzufuhr bei einer unzulässig hohen Temperatur mit größtmöglicher Zuverlässigkeit ermöglicht. Dazu wird ein Leiterbahnabschnitt, der den zu schaltenden Strom einem Halbleiterschaltelement zuführt, mechanisch unterbrochen. Unterhalb der Leiterbahn ist dazu ein vorgespanntes Betätigungselement angeordnet, dass bei einer Temperatur über einer voreinstellbaren Grenztemperatur die Leiterbahn unterbricht.

## Patentansprüche

1. Steuereinheit mit einer wenigstens eine Leiterbahn umfassenden Leiterplatte (1) und einem auf der Leiterplatte (1) befestigten und elektrisch mit der wenigstens einen Leiterbahn verbundenen Transistor (2),
**gekennzeichnet durch**
ein Unterbrecherelement (3), welches in seiner gegenüber der Leiterplatte (1) festgelegten Ausgangsstellung gegenüberliegende Enden der wenigstens einen Leiterbahn elektrisch miteinander verbindet, und
ein bei Überhitzung des Transistors (2) aktiviertes Betätigungselement (4), welches bei Betätigung gegen das Unterbrecherelement (3) wirkt und dieses zumindest so weit von der Leiterplatte (1) löst, dass die elektrische Verbindung unterbrochen ist, wobei das Betätigungselement (4) in seiner Ausgangslage vorgespannt **durch** ein thermisch mit dem Transistor (2) gekoppeltes Schmelzelement (5) gesichert ist.

2. Steuereinheit nach Anspruch 1, **dadurch gekennzeichnet, dass** das Schmelzelement (5) auf der dem Transistor (2) abgewandten Seite der Leiterplatte (1) angeordnet ist und dass die Leiterplatte (1) eine sich zwischen dem gegen die Leiterplatte (1) gesicherten Schmelzelement und dem Transistor (2) erstreckende Wärmeleitbahn aufweist.

3. Steuereinheit nach einem der vorherigen Ansprüche, **dadurch gekennzeichnet, dass** das Unterbrecherelement durch ein auf die Leiterplatte (1) aufgelötetes Kontaktblech (3) gebildet ist und dass die transistorseitige Lötverbindung (23) zwischen der Leiterplatte (1) und dem Kontaktblech (3) thermisch mit dem Transistor (2) gekoppelt ist.

4. Steuereinheit nach Anspruch 3, **dadurch gekennzeichnet, dass** die Leiterplatte (1) eine unter dem Kontaktblech (3) ausgesparte Betätigungsöffnung (7) aufweist, in der das betätigungsseitige Ende des Betätigungselementes (4) in seiner Ausgangslage aufgenommen ist.

5. Steuereinheit nach einem der vorherigen Ansprüche, **dadurch gekennzeichnet, dass** das Betätigungselement durch ein gegenüber der Leiterplatte (1) festgelegtes Stanzbiegeteil (4) gebildet ist, welches ein elastisch umbogenes Bogensegment, ein mit einer Aufnahme (20) zur Halterung des Schmelzelementes (5) versehenes Aufnahmesegment (17) und ein sich zwischen dem Bogensegment (15) und dem Aufnahmesegment (17) erstreckendes Verbindungssegment (16) umfasst, von dem ein durch Einschneiden des Verbindungssegmentes (16) gebildeter, in etwa rechtwinkelig zu der Leiterplatte (1) umbogener Betätigungssteg (18) abgeht.

6. Steuereinheit nach einem der vorherigen Ansprüche, **dadurch gekennzeichnet, dass** das Betätigungselement (4) in einem Aufnahmegehäuse (6) vormontiert ist, welches mit der Leiterplatte (1) verbunden ist und in dem das Betätigungselement (4) vor dem Verbinden mit der Leiterplatte (1) durch ein Riegelelement (26) unter Vorspannung gehalten ist, welches nach dem Verbinden des Aufnahmegehäuses (6) mit der Leiterplatte (1) das Betätigungselement (4) freigibt.

7. Steuereinheit nach Anspruch 4, **dadurch gekennzeichnet, dass** das Riegelelement (26) vor dem Verbinden des Aufnahmegehäuses (6) mit der Leiterplatte (1) eine Montagefläche des Aufnahmegehäuses (6) überragt und dass das Riegelelement (26) verschwenkbar an dem Aufnahmegehäuse (6) gelagert ist und eine bei der Vormontage mit dem Betätigungselement (4) zusammenwirkende Ablauframpe (27) aufweist, der eine das vormontierte Betätigungselement (4) unter Vorspannung haltende Montagefläche (28) nachgeordnet ist.

8. Steuereinheit nach einem Ansprüche 5 oder 6, **dadurch gekennzeichnet, dass** das Aufnahmegehäuse (6) zusammen mit dem Riegelelement (26) als einteiliges Spritzgießteil ausgebildetes ist.

9. Steuereinheit nach einem der vorherigen Ansprüche, **dadurch gekennzeichnet, dass** das Aufnahmegehäuse (6) mit der Leiterbahn (1) verrastet ist.

10. Steuereinheit nach einem der Ansprüche 6 bis 9, **dadurch gekennzeichnet, dass** das Stanzbiegeteil (4) in dem Aufnahmegehäuse (6) verrastet ist.

11. Steuereinheit nach einem der Ansprüche 6 bis 10, **dadurch gekennzeichnet, dass** das Aufnahmegehäuse (6) einen Aufnahmeschlitz (32) zur Halterung eines sich an das Bogensegment (15) anschließenden Befestigungssegmentes (13) des Stanzbiegeteiles (4) umfasst.

12. Elektrische Heizvorrichtung mit einem Vorrichtungsgehäuse (40), das einen Schichtaufbau besehend aus wenigstens einem Radiatorelement (50), wenigstens einem Kontaktblech (44) und wenigstens einem wärmeabgebenden Element (43) hält, **gekennzeichnet durch** eine Steuereinheit nach einem der Ansprüche 1 bis 11 zur Steuerung der Heizleistung des wenigstens einen wärmeabgebenden Elementes (43).

13. Elektrische Heizvorrichtung mit einem Aufnahmegehäuse, welches eine sich quer zu den wärmeabgebenden Elementen (43) erstreckende und diese elektrisch isoliert voneinander abstützende Querstrebe (42a) umfasst, nach Anspruch 12, **dadurch gekennzeichnet, dass** die Leiterplatte (1) und das Betätigungselement (4) von der Querstrebe (42a) gehalten sind.

## Claims

1. Control unit with a circuit board (1) comprising at least one track and a transistor (2) mounted on the circuit board (1) and electrically connected to the at least one track,
**characterised by**
an interrupter element (3), which in its initial position defined with respect to the circuit board (1) electrically connects opposite facing ends of the at least one track and
an actuating element (4), activated on overheating of the transistor (2), and which acts against the interrupter element (3) on actuation and releases it at least so far from the circuit board (1) that the electrical connection is interrupted, the actuating element (4) is secured in its initial position pretensioned by a fusible element (5) thermally coupled to the transistor (2).

2. Control unit according to claim 1, **characterised in that** the fusible element (5) is arranged on the side of the circuit board (1) facing away from the transistor (2) and that the circuit board (1) exhibits a thermal track extending between the fusible element secured against the circuit board (1) and the transistor (2).

3. Control unit according to any of the previous claims, **characterised in that** the interrupter element is formed by a contact plate (3) soldered on the circuit board (1) and that the solder connection (23) on the transistor side between the circuit board (1) and the contact plate (3) is thermally coupled to the transistor (2).

4. Control unit according to claim 3, **characterised in that** the circuit board (1) exhibits an actuating opening (7) cut out under the contact plate (3), in which the end of the actuating element (4) at the actuating side is accommodated in its initial position.

5. Control unit according to any of the previous claims, **characterised in that** the actuating element is formed by a press-bent part (4) defined with respect to the circuit board (1) and which comprises an elastically bent curved segment, an accommodation segment (17) provided with a receptacle (20) for holding the fusible element (5) and a connecting segment (16) extending between the curved segment (15) and the accommodation segment (17), from which an actuating web (18) formed through cutting into the connecting segment (16) and bent approximately at right angles to the circuit board (1) branches.

6. Control unit according to any of the previous claims, **characterised in that** the actuating element (4) is preassembled in an accommodation housing (6), which is connected to the circuit board (1) and in which the actuating element (4) is held under pretension before connection to the circuit board (1) by a latching element (26), which releases the actuating element (4) after connecting the accommodation housing (6) to the circuit board (1).

7. Control unit according to claim 4, **characterised in that** the latching element (26) overlaps a mounting surface of the accommodation housing (6) before connection of the accommodation housing (6) to the circuit board (1) and that the latching element (26) is supported for swivelling on the accommodation housing (6) and exhibits a run-off ramp (27), which interacts during the preassembly with the actuating element (4) and which is followed by a mounting surface (28) which holds the preassembled actuating element (4) under pretension.

8. Control unit according to claim 5 or 6, **characterised in that** the accommodation housing (6) is formed together with the latching element (26) as a one-piece injection moulded part.

9. Control unit according to any of the previous claims, **characterised in that** the accommodation housing (6) is latched to the circuit board (1).

10. Control unit according to any of claims 6 to 9, **characterised in that** the punched deflector (4) is latched in the accommodation housing (6).

11. Control unit according to any of claims 6 to 10, **characterised in that** the accommodation housing (6) comprises an accommodation slot (32) for holding a mounting segment (13) of the press-bent part (4) connecting to the curved segment (15).

12. Electrical heating device with a device housing (40), which holds a layer structure consisting of at least one radiator element (50), at least one contact plate (44) and at least one thermally dissipating element (43), **characterised by** a control unit according to one of the claims 1 to 11 for the control of the heater power of the at least one thermally dissipating element (43).

13. Electrical heating device with an accommodation housing, which comprises a lateral strut (42a) extending laterally to the thermally dissipating elements (43) and which spaces them for electrical insulation, according to claim 12, **characterised in that** the circuit board (1) and the actuating element (4) are held by the lateral strut (42a).

## Revendications

1. Unité de commande comprenant une plaquette à circuit imprimé (1) comprenant au moins une piste conductrice et un transistor (2), fixé sur la plaquette à circuit imprimé (1) et relié électriquement à au moins une piste conductrice,
**caractérisée par**
un élément interrupteur (3), qui, dans sa position initiale, fixée par rapport à la plaquette à circuit imprimé (1), relie ensemble électriquement des extrémités opposées de la au moins une piste conductrice, et
un élément d'actionnement (4), activé en cas de surchauffe du transistor (2) et qui, en cas d'actionnement, agit contre l'élément interrupteur (3) et détache celui-ci de la plaquette à circuit imprimé (1) en le plaçant au moins à distance, de sorte que la liaison électrique est interrompue,
dans laquelle l'élément d'actionnement (4), dans sa position initiale, est sécurise de manière précontrainte par l'intermédiaire d'un élément fusible (5) couplé thermiquement au transistor (2).

2. Unité de commande selon la revendication 1, **caractérisée en ce que** l'élément fusible (5) est disposé sur le côté de la plaquette à circuit imprimé (1) opposé au transistor (2), et **en ce que** la plaquette à circuit imprimé (1) présente une piste conductrice de la chaleur, s'étendant entre l'élément fusible réalisé contre la plaquette à circuit imprimé (1) et le transistor (2).

3. Unité de commande selon l'une des revendications précédentes, **caractérisée en ce que** l'élément interrupteur est formé par une tôle de contact (3) rapportée par brasage sur la plaquette à circuit imprimé (1), et **en ce que** la liaison brasée (23) située côté transistor est couplée thermiquement au transistor (2), entre la plaquette à circuit imprimé (1) et la tôle de contact (3).

4. Unité de commande selon la revendication 3, **caractérisée en ce que** la plaquette à circuit imprimé (1) présente une ouverture d'actionnement (7) ménagée au-dessous de la tôle de contact (3), ouverture dans laquelle l'extrémité de l'élément d'actionnement (4), située côté actionnement, est logée dans sa position initiale.

5. Unité de commande selon l'une des revendications précédentes, **caractérisée en ce que** l'élément d'actionnement est formé par une pièce emboutie estampée (4), fixée par rapport à la plaquette à circuit imprimé (1) et comprenant un segment d'arc replié élastiquement, un segment de logement (17), muni d'un logement (20) pour la fixation de l'élément fusible (5), et un segment de liaison (16) s'étendant entre le segment d'arc (15) et le segment de logement (17), d'où s'étend une nervure d'actionnement (18) formée par entaillage du segment de liaison (16), repliée à peu près à angle droit par rapport à la plaquette à circuit imprimé (1).

6. Unité de commande selon l'une des revendications précédentes, **caractérisée en ce que** l'élément d'actionnement (4) est prémonté dans un boîtier de logement (6), relié à la plaquette à circuit imprimé (1) et dans lequel l'élément d'actionnement (4) est maintenu sous précontrainte au moyen d'un élément de verrouillage (26) avant la liaison à la plaquette à circuit imprimé (1), l'élément de verrouillage libérant l'élément d'actionnement (4) après la liaison du boîtier de logement (6) à la plaquette à circuit imprimé (1).

7. Unité de commande selon la revendication 4, **caractérisée en ce que**, avant la liaison du boîtier de logement (6) à la plaquette à circuit imprimé (1), l'élément de verrouillage (26) fait saillie d'une surface de montage du boîtier de logement (6), et **en ce que** l'élément de verrouillage (26) est monté à pivotement sur le boîtier de logement (6) et présente une rampe de descente (27) coopérant avec l'élément d'actionnement (4) lors du prémontage, rampe en aval de laquelle est disposée une surface de montage (28) maintenant sous précontrainte l'élément d'actionnement (4) ayant été prémonté.

8. Unité de commande selon l'une des revendications 5 ou 6, **caractérisée en ce que** le boîtier de logement (6) est réalisé, conjointement avec l'élément de verrouillage (26), sous forme de pièce moulée par injection monobloc.

9. Unité de commande selon l'une des revendications précédentes, **caractérisée en ce que** le boîtier de logement (6) est encliqueté à la piste conductrice (1).

10. Unité de commande selon l'une des revendications 6 à 9, **caractérisée en ce que** la pièce emboutie estampée (4) est encliquetée dans le boîtier de logement (6).

11. Unité de commande selon l'une des revendications 6 à 10, **caractérisée en ce que** le boîtier de logement (6) comprend une fente de logement (32) pour fixation d'un segment de fixation (13) de la pièce emboutie estampée (4), se raccordant au segment d'arc (15).

12. Dispositif de chauffage électrique comprenant un boîtier de dispositif (40), présentant une structure en couche composée d'au moins un élément radiateur (50), d'au moins une tôle de contact (44) et d'au moins un élément dissipateur de chaleur (43), **caractérisé par** une unité de commande selon l'une des revendications 1 à 11, pour la commande de la puissance de chauffage du au moins un élément dissipateur de chaleur (43).

13. Dispositif de chauffage électrique avec un boîtier de dispositif comprenant une entretoise transversale (42a) s'étendant transversalement par rapport aux éléments dissipateurs de chaleur (43) et entourant ceux-ci isolés électriquement les uns des autres, selon la revendication 12, **caractérisé en ce que** la plaquette à circuit imprimé (1) et l'élément d'actionnement (4) sont maintenus par l'entretoise transversale (42a).
